(19) Europäisches Patentamt / European Patent Office / Office européen des brevets

(11) **EP 3 956 978 B1**

(12) **EUROPEAN PATENT SPECIFICATION**

(45) Date of publication and mention
of the grant of the patent:
**06.12.2023 Bulletin 2023/49**

(21) Application number: **20704103.9**

(22) Date of filing: **04.02.2020**

(51) International Patent Classification (IPC):
*H02S 20/24* (2014.01)    *H01L 31/048* (2014.01)
*H02S 30/00* (2014.01)    *H01L 31/042* (2014.01)
*H02S 20/00* (2014.01)

(52) Cooperative Patent Classification (CPC):
**H02S 20/24; H01L 31/042; H01L 31/048;
H02S 20/00; H02S 30/00**

(86) International application number:
**PCT/NL2020/050061**

(87) International publication number:
**WO 2020/214024 (22.10.2020 Gazette 2020/43)**

(54) **SOLAR PANEL PRODUCT COMPRISING A TAPER**

SOLARPANEELPRODUKT MIT EINEM KEGEL

PRODUIT DE PANNEAU SOLAIRE COMPRENANT UN CÔNE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.04.2019 NL 2022944
26.07.2019 PCT/NL2019/050501**

(43) Date of publication of application:
**23.02.2022 Bulletin 2022/08**

(73) Proprietor: **Solarge Holding B.V.
5641 TD Eindhoven (NL)**

(72) Inventors:
• **SELTEN, Wilhelmus Nicolaas Maria
5641 TD Eindhoven (NL)**
• **ZWEGERS, Stefan Henricus Maria
5641 TD Eindhoven (NL)**
• **VAN DE VEN, Marcus Leonardus Gerardus Maria
5641 TD Eindhoven (NL)**
• **DE LEEDE, Gerardus Leonardus Antonius
5641 TD Eindhoven (NL)**

• **VAN DEN DONKER, Menno Nicolaas
5641 TD Eindhoven (NL)**
• **VISSCHER, Harm
5641 TD Eindhoven (NL)**
• **VAN DEN HEUVEL, Huibert Johan
5641 TD Eindhoven (NL)**
• **VERLAEK, Roeland Leonardus Hubertus Maria
5641 TD Eindhoven (NL)**
• **OOMEN, Emmanuel Wilhelmus Johannes
Leonardus
5641 TD Eindhoven (NL)**

(74) Representative: **V.O.
P.O. Box 87930
2508 DH Den Haag (NL)**

(56) References cited:
**WO-A1-2014/056176    WO-A1-2017/172056
WO-A1-2018/024948    WO-A2-2017/081538
DE-U1- 20 008 441    US-A1- 2009 320 898
US-A1- 2017 278 985    US-A1- 2017 338 767
US-A1- 2018 316 302    US-A1- 2019 183 215**

**Description**

TECHNICAL FIELD AND BACKGROUND

The present disclosure relates to a solar panel product, assemblies thereof, and to methods for the manufacturing thereof.

Photovoltaic products become more and more widespread, due to the steadily decreasing costs of material, the increasing efficiency and the need for more sustainable energy sources.

Known photovoltaic panels, also known as solar panels, typically comprise, in order from the front light-receiving side to the back: a protective front layer, a layer comprising interconnected photovoltaic elements and a back layer. Glass is widely used for the protective front layer as being suitable to, in use, protect the photovoltaic panels from externally induced damage, e.g. due to weather conditions such as rain and hail, while being sufficiently transparent to allow incident light to reach the photovoltaic cells. Also polymeric materials, having the advantage of a lower weight, are applied for this purpose. The back layer may also be a glass sheet, or a metal sheet or any other panel such as polymer-based panels suitable to its purpose of providing electrical insulation of the photovoltaic elements and providing a weather tight closure to the back of the photovoltaic elements.

Typically solar panels are mounted under a slanting angle. An advantage thereof is that incoming water, e.g. rain may run off the surface of the panel. Solar panels are typically mounted under an angle in excess of 10° with respect to level. By placing solar panels under an angle sufficient to drain off incoming water, contamination on the panel surface, e.g. by growth of biological material such as algae or moss may be reduced. Further panels mounted under a sufficient angle may be passive cleaned, e.g. due to incident rain washing away contamination, e.g. sand, dust, and/or soot. In order to achieve such orientation, panels including a mounting frame are commonly mounted onto a dedicated carrier structure. For example, for flat or very shallow rooftops such mounting structure may include a metallic frame that is secured to the roof. Besides assembly time and costs the weight of such dedicated carrier structures is disadvantageous.

Korean patent application KR20190024303 discloses a solar light power generation structure that comprises one or more pyramids having a plurality of inclined planes and comprising a solar light panel provided to at least one of the plurality of inclined planes to collect solar light. It is observed therein that this construction enables an efficient solar energy collection at a relatively small installation area. Other examples are provided in patent publications US 2019/183215, US 2017/278985, WO2014056176.

WO2017081538 A2 describes a solar panel product comprising a taper.

US 2019/183215 provides a sunshade umbrella, which includes an umbrella rod, an umbrella body at an end of the umbrella rod, an umbrella handle at an opposite end of the umbrella rod, a solar cell component, a current output structure in the umbrella handle and in an electrical connection with the solar cell component, a first connection structure at the umbrella body and a second connection structure at the solar cell component. The solar cell component is detachably mounted to the umbrella body through detachable engagement between the first connection structure and the second connection structure.

US 2017/278985 discloses a solar energy device includes a solar panel array including a plurality of solar panels, each of the solar panels being divided into solar sub-panels. The solar sub-panels have unequal shapes but equal areas. Wires electrically connect the solar sub-panels and connect the solar panels. The solar panels are secured on a base which is formed with cutouts to receive the wires. The wires are fixed to the solar sub-panels but are free to move with respect to the base.

WO2014056176 pertains to a solar power supply apparatus that comprises: a solar panel group; a transmission mechanism connected to the solar panel group and a rotary outer shaft through a connection structure; a motor used to drive the transmission mechanism to rotate, and make the solar panel group rotate through the connection structure; and a connection unit used to supply power generated by the solar panel group to a first wire group. According to the apparatus, a solar battery panel group can rotate under wind, and use the motor to rotate without wind, improving solar utilization efficiency.

When considering installation of a solar panel construction, it is important to take into account the expected/possible mechanical forces exerted on the carrier surface, such as a roof of a building, where the construction is to be located. These include the force exerted by the weight of the solar construction and forces due to the wind, which is unpredictable in direction and strength.

The wind load is a determining factor when designing mounting systems for solar modules on any type of surface. In general, the wind load creates a pressure load due to direct wind pressure on surfaces that are 'in the wind' (both sideways, also called drag, as well as vertically, typically a downward force on surfaces that are tilted up, called downforce, and upward force on surfaces that are tilted down, called lift) and a suction load, so upward lift force, on subjects that 'deviate from the direction of the wind'. The magnitude of these forces depends on the location of the system, the height of the ground measured, the shape of the object on which the installation is mounted and the exact position of the installation on the object. In addition to the possible snow load, the above-mentioned forces typically determine the force play on the mounting structure. The installation costs of a solar installation consist of the material costs for the mounting structure and the working hours involved in the installation. Installation costs are starting to play an ever greater role in the total cost price of an installed solar system. This is because the costs of the solar modules steadily decrease, while the costs for mounting stay at the same level or even tend to increase due to the limited availability of skilled personnel in combination with the high demand for installation capacity.

Commonly available solar panel installations typically have a relatively large weight. Often the solar panels are formed of glass which has a relatively high weight. Even if lighter construction materials are used the panels are typically provided in combination with a carrier construction that is weighted with ballast. This is to ensure that the solar installation does not blow away even in the case that substantial wind forces prevail.

When constructing a new building the roof may be designed explicitly as a carrier surface for this purpose. However, many existing buildings do not have a roof designed to withstand the weight of such solar panel installations. As an alternative it may be contemplated to anchor the carrier construction to the roof, therewith allowing for a reduction of the weight of the carrier construction. However, this involves additional work to mount the solar panel installation to the roof and additionally involves the risk that the water tightness of the roof is affected.

Accordingly, there exists a desire for solar panel products having a relatively low weight that need not be anchored to a roof surface.

SUMMARY

It is an object of the present disclosure, to provide solar panel installation having a relatively low weight while mitigating the need to anchor the installation to a roof surface.

In accordance with this object, a solar panel product is provided that comprises a taper having a base plane to be carried by a supporting surface and a top, the taper having a taper wall that extends around an axis from the base plane to the top, the taper wall tapering inwards in the direction from the base plane to the top, wherein at least a part of an outer area of the taper wall is provided with a photovoltaic layer, the solar panel product having one or more openings at a top side.

During use, the pyramidal solar panel when being installed on a roof or on a sea surface is exposed to wind having a direction and speed which is unpredictable. As observed above, in general, the wind load creates a pressure load due to direct wind pressure on surfaces that are 'in the wind' (both sideways, also called drag, as well as vertically, typically a downward force on surfaces that are tilted up, called downforce, and upward force). on surfaces that are tilted down, called lift) and a suction load, so upward lift force, on subjects that 'deviate from the direction of the wind'.

In the pyramidal solar panel as claimed herein, one or more openings are provided at a side of the top. As a result, the wind passing along the one or more openings induce an under pressure inside the pyramidal solar panel. Therewith lift forces are compensated, so that the need to anchor the installation is mitigated.

More in particular, this is explained as follows. The shape of the taper results in an increased air speed above its top therewith creating a relatively low air pressure above the taper, i.e. below the environmental air pressure. The interior of the taper, assumes the relatively low pressure through the opening in or near the top. The lower parts of the side(s) of the taper may further experience an overpressure as a result of air being compressed when ascending against the taper wall. With a relatively flat pyramid (i.e. the taper wall has an inclination of at most 25 degrees with respect to the base plane), the pressure on the lee side (away from the wind) will be reasonably the same as on the windward side (towards the wind). With a larger inclination there will be more suction on the lee side and there is a chance that the side will start to lift. The inclination may for example be approximately 10 degrees, so that water still rinses well off the surfaces while the variation in orientation of PV surfaces on the taper wall towards the sun does not induce substantial difference with regard to energy yield measured over a 24-hour period.

In an embodiment, one or more extension parts are provided at the top side of the taper wall that extend in a direction away from the base side. The one or more extension parts may for example be provided as a collar, e.g. a cylindrical collar for a cone shaped taper or a collar formed of mutually neighboring vertically arranged planar sections, one for each top side of a pyramid wall. This has the effect that the (partly) laminar airflow becomes turbulent at the opening above the pyramid through the edge of the hole (s). As a result, less wind suction occurs on the rear / lee side of the pyramid, which further reduces the lifting force on the pyramid. Placing an outwardly protruding edge around the hole, also in the form of a chimney, will help to strengthen the separation of the air flow. This is certainly the case with a large field of pyramids where the air speed above the pyramids further away from the edge of the field decreases due to the increasing amount of turbulence of the air above the field. For small fields, the chimney does not have to be high, for example a few cm, for a very large field, the height may well be 50 cm or more for proper operation. In that case it is favorable if the chimney is of a translucent material.

In order to avoid that water and, for example, leaves accumulate in the taper, it may for example be arranged with short legs (e.g. having a length of 1 or 2 cm) above a roof. Alternatively, one or more tapers may be mounted on a draining mat placed on the roof. By way of example a plurality of tapers may be mounted on one draining mat and several mats such mats may be mounted to the roof to provide for a large, interconnected structure that can be installed quickly.

The taper may be provided with a bottom wall at its base side, but this is not necessary. A bottom wall may be not desired as it would involve additional costs. Moreover, in the absence of a bottom wall, the tapered solar panel products can be easily stacked for transport and storage. Should nevertheless a bottom wall be provided, then measures should be taken to avoid that water and, for example, leaves accumulate in the taper. As an example, a taper may be provided with a bottom wall allowing it to float on a sea surface. In that case a pump, e.g. driven by power delivered from the photovoltaic layer, may be provided to pump water out of the interior when it exceeds a predetermined level. Alternatively, when the taper is provided on a roof or the like, drainage openings may be provided in the bottom wall or in the taper wall near the base side.

Due to these measures openings may be present near the base side, i.e. the drainage openings in the bottom wall or the openings along the edge(s) at the base side when the taper is arranged by legs above the roof. In that case, a total surface area defined by these one or more further openings should be at most equal to a total surface area of the one or more openings at its top side, so that the interior of the taper is maintained at a sufficiently low pressure when it is subjected to wind. With a pyramid that is closed at the bottom, a small opening at the top is sufficient, for example smaller than 5% of the surface area of the base.

BRIEF DESCRIPTION OF THE DRAWINGS

These and other aspects are described in more detail with respect to the drawings. Therein:

FIG. 1 schematically shows an embodiment of a solar panel product as claimed herein;
FIG. 2A, 2B are perspective views of two further embodiments of a solar panel product as claimed herein;
FIG. 3A, 3B respectively show a top view and a side view (according to IIIB in FIG.3A) of a still further embodiment of a solar panel product as claimed herein;
FIG. 4 is a perspective view of another further embodiment of a solar panel product as claimed herein;
FIG. 5 schematically shows exemplary electric interconnections in an embodiment of a solar panel product as claimed herein;
FIG. 6A-6D schematically show an aspect of an embodiment of a method of manufacturing a solar panel product as claimed herein;
FIG. 7A, 7B show aspects of an alternative method of a method of manufacturing a solar panel product as claimed herein;
FIG. 8 is a perspective view of an alternative embodiment of a solar panel product as claimed herein;
FIG. 9A-9C schematically shows an embodiment of a method of manufacturing a solar panel product as shown in FIG. 8;.
FIG. 10A-10C schematically shows an embodiment of a method of manufacturing a variation of the solar panel product as shown in FIG. 8;
FIG. 11A schematically shows an example of a back panel suitable for use in various embodiments of the claimed solar panel products and their methods of manufacturing;
FIG. 11B shows how the back panel of FIG. 11A may be used in a solar panel product;
FIG. 12A, 12B show examples of a solar panel product arrangement comprising a plurality of the claimed solar panel products.
FIG. 13A and 13B show simulation results;
FIG. 14 schematically shows wind tunnel test arrangements for various claimed an non-claimed products.
FIG. 15 and 16 show further embodiments of a solar panel product arrangement.

DETAILED DESCRIPTION OF EMBODIMENTS

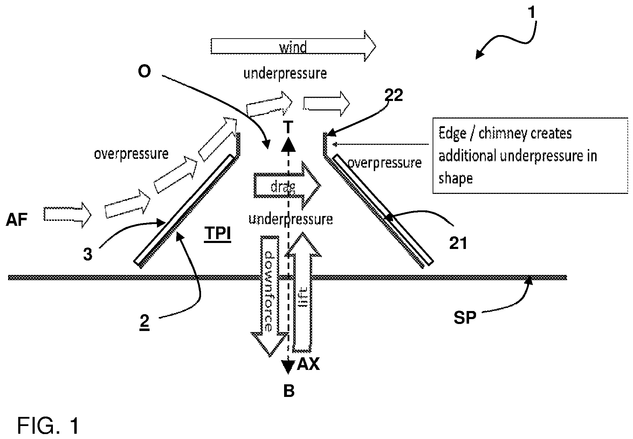

In the following figures corresponding elements have the same reference. In some cases exemplary products are not necessarily drawn to scale. Measures may have been exaggerated for clarity purposes. For example the figures 1, 8, 9A and 9B show examples with a side-wall inclination that is relatively high in comparison to what in practice would be applied.

FIG. 1 schematically shows a solar panel product 1, comprising a taper 2, e.g. a pyramid or a cone, that is to be carried at a base side B by a supporting surface SP and that has a top side T opposite the base side B. The taper 2 has a taper wall 21 that extends around an axis AX from the base side to the top side. The taper wall 21 tapers inwards in the direction from the base side B to the top side T. At least a part of an outer area of the taper wall 21 is provided with a photovoltaic layer 3. The solar panel product 1 has one or more openings at its a top side T. In the embodiment shown, an opening O is provided in that the taper 2 is truncated at its top side.

As schematically shown in FIG. 1, air AF flowing in the direction of the taper wall 21 is forced upwards. Therewith the air flow velocity at the top side T of the taper 2 is relatively high as compared to the air flow velocity nearer the base side B. As a result the air pressure near the opening O "underpressure" is lower than the average environmental pressure. The interior TPI of the taper 2 being in contact with the exterior through the opening O also assumes that relatively low pressure.

In the embodiment shown, the solar panel product 1 has one or more extension parts 22 extending from the top side of the taper wall 21 in a direction away from the base side B. The extension parts 22 may for example comprise a cylindrical extension part when the taper 2 is a cone, or may comprise respective rectangular sections, each extending from a respective truncated pyramid wall if the taper 2 is a pyramid.

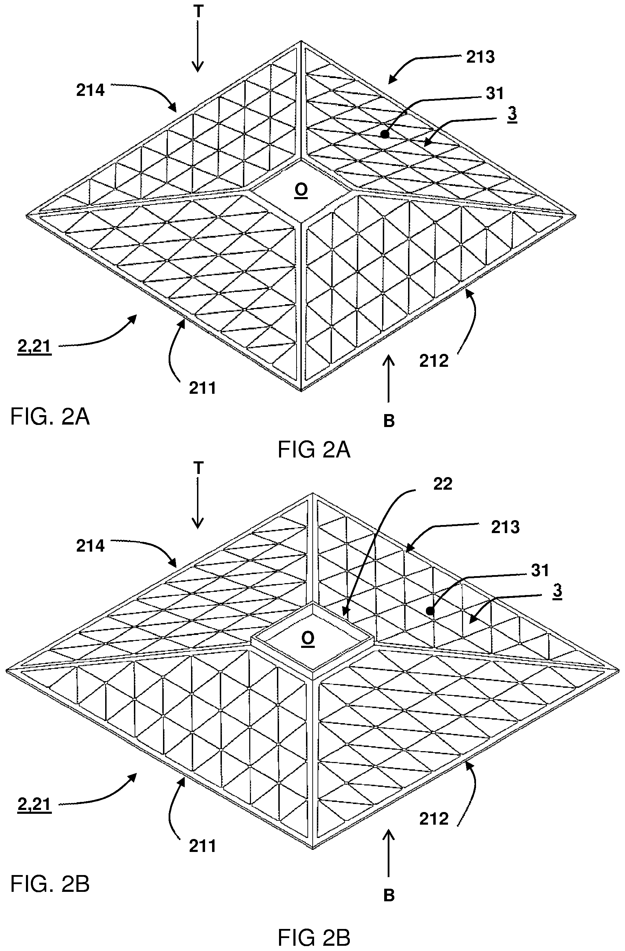

FIG. 2A shows an example, wherein the taper 2 is provided as a four-sided truncated pyramid having a taper wall 21 comprising four trapezoidal shaped planar sections 211, 212, 213, 214. Each of these planar sections is provided with a photovoltaic layer 3 with photovoltaic cells 31.

The embodiment of FIG. 2B differs from the embodiment of FIG. 2A, in that a extension part 22 is provided at the topside T.

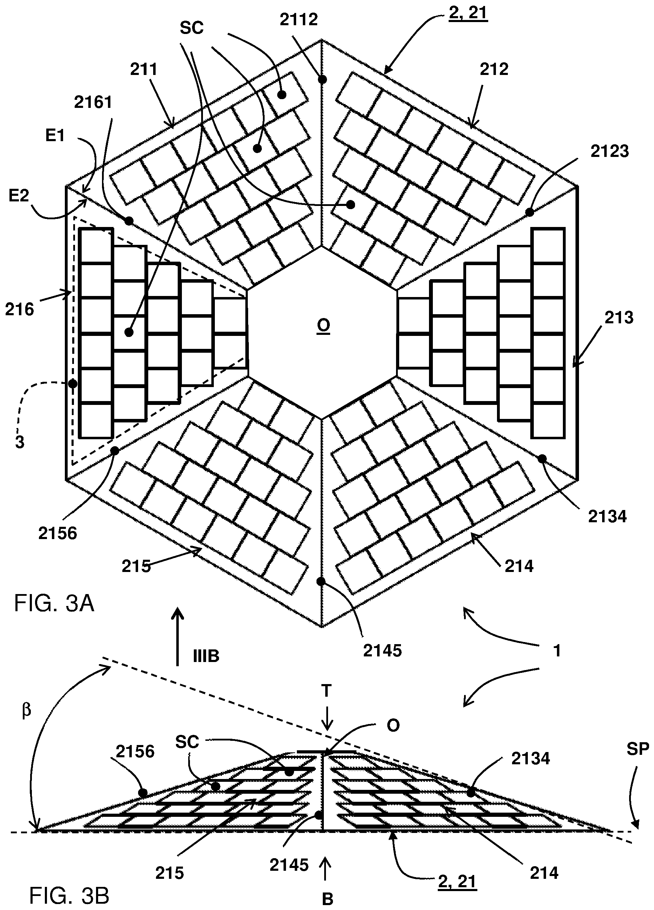

FIG. 3A, 3B shows another example of the solar panel product 1. FIG. 3A shows a top-view and FIG. 3B shows a side-view according to IIIB in FIG. 3B. Therein the taper 2 is provided as a six-sided truncated pyramid having a taper wall 21 comprising six trapezoidal shaped planar sections 211, 212, 213, 214, 215, 216. In this example, the planar sections correspond to sections of a thermoplastically deformable back panel, and the planar sections are pairwise connected in a respective plastically deformed section 2112, 2123, 2134, 2145, 2156, 2161. Alternatively, the trapezoidal shaped planar sections 211, 212, 213, 214, 215, 216 may be formed of as sections of another substrate, such as glass. In that case the trapezoidal shaped planar sections may be adhered to each other with an adhesive material, or may be mutually connected with a carrier construction. The taper 2 is provided as a relatively flat pyramid, i.e. the taper wall has an inclination $\beta$ of at most 25 degrees with respect to the support SP that carries the base plane. Therewith the pressure on the lee side (away from the wind) will be reasonably the same as on the windward side (towards the wind). With a larger inclination there will be more suction on the lee side and there is a chance that the side will start to lift. The inclination may for example be approximately 10 degrees, so that water still rinses well off the surfaces while the variation in orientation of PV surfaces on the taper wall towards the sun does not induce substantial difference with regard to energy yield measured over a 24-hour period.

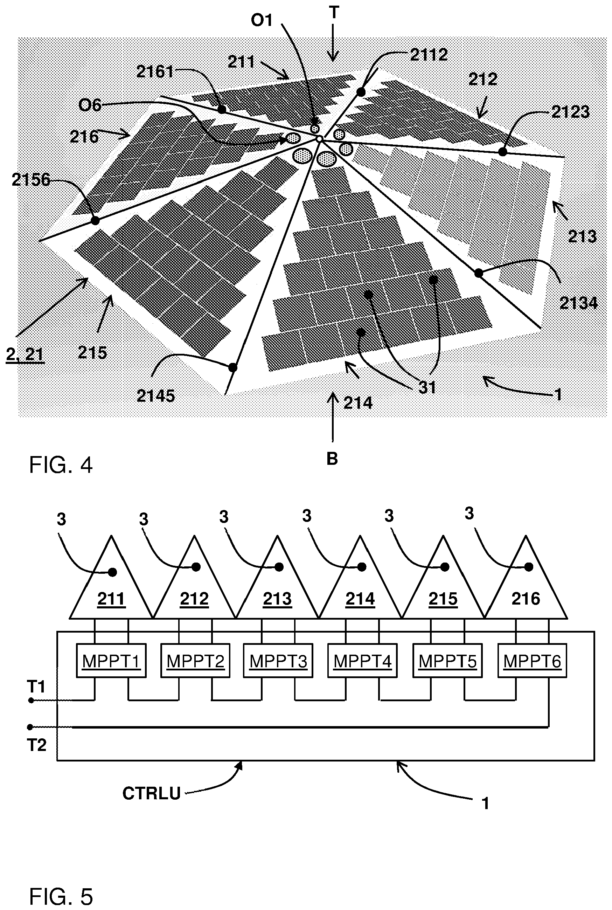

FIG. 4 shows another example wherein the taper 2 is provided as a six-sided truncated pyramid having a taper wall 21 comprising six trapezoidal shaped planar sections 211, 212, 213, 214, 215, 216. In this case the planar sections are triangles, and each of the triangular planar sections of the taper wall 21 is provided with an opening. E.g. an opening O1 is provided in triangular planar section 211 and an opening O6 is provided in triangular planar section 216.

FIG. 5 schematically shows a solar panel product 1, for example the product of FIG.2A, 2B or FIG3 that is additionally provided with a control unit CTRLU. The control unit CTRLU has a respective Maximum Power Point Tracker MPPT1,...,MPPT6 for each photovoltaic layer 3 associated with a respective one of the planar sections of the pyramidal taper wall 21. The outputs of the trackers are arranged in series between output terminals T1, T2. The control unit is analogously applicable to the embodiments of FIG. 2A, 2B.

Alternatively, it could be contemplated to simply arrange the photovoltaic layers of the sections 211,...,216 in series, bridging each of the sections with a bypass diode. However in that case sections that have a lower light exposure would limit the power output or not contribute any output power (depending on the type of bypass device), whereas in the embodiment of FIG. 5 they still do provide an optimal contribution.

In another configuration, the photovoltaic layers of the section 211,...,216 are connected in parallel. In this case the sections can deliver their contribution in proportion to the light exposure. As compared to the configuration of FIG. 5, however, this parallel configuration would operate at a lower output voltage and a higher output current, and therewith result in higher resistive losses and the requirement of thicker, more expensive cables.

In a still further configuration, the corresponding sections of mutually different solar panel products 1 are arranged in series. This would have the advantage that the serial connection is provided for solar panel elements having a comparable light exposure, so that all sections efficiently contribute. This configuration however involves significant cabling costs, as a multitude of cables has to be provided. In the case of a hexagonal pyramid arrangement a first set of two cables (+ and -) would be required for the S1 sections of a series of pyramids, a second set for the S2 sections, etc., resulting in a total of six sets of cables.

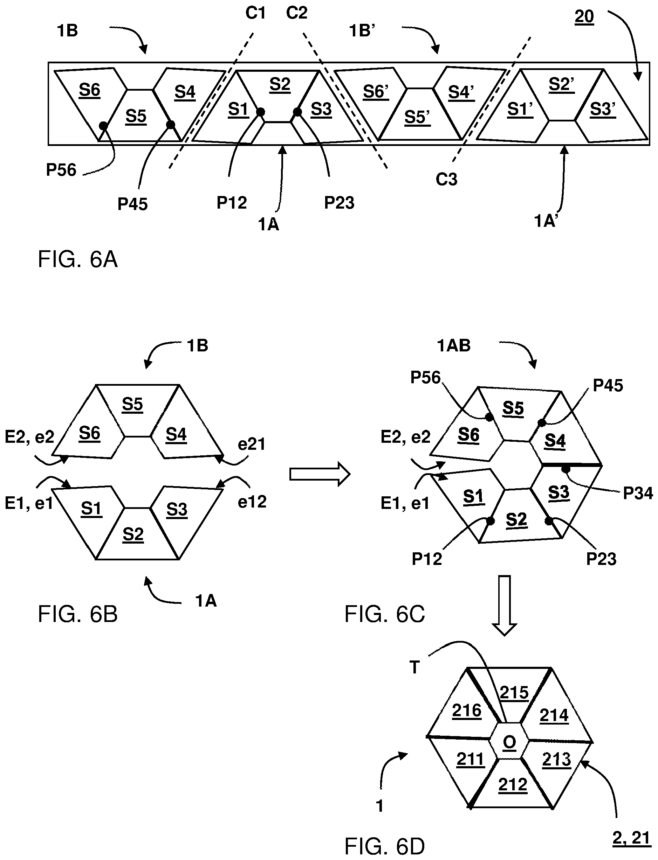

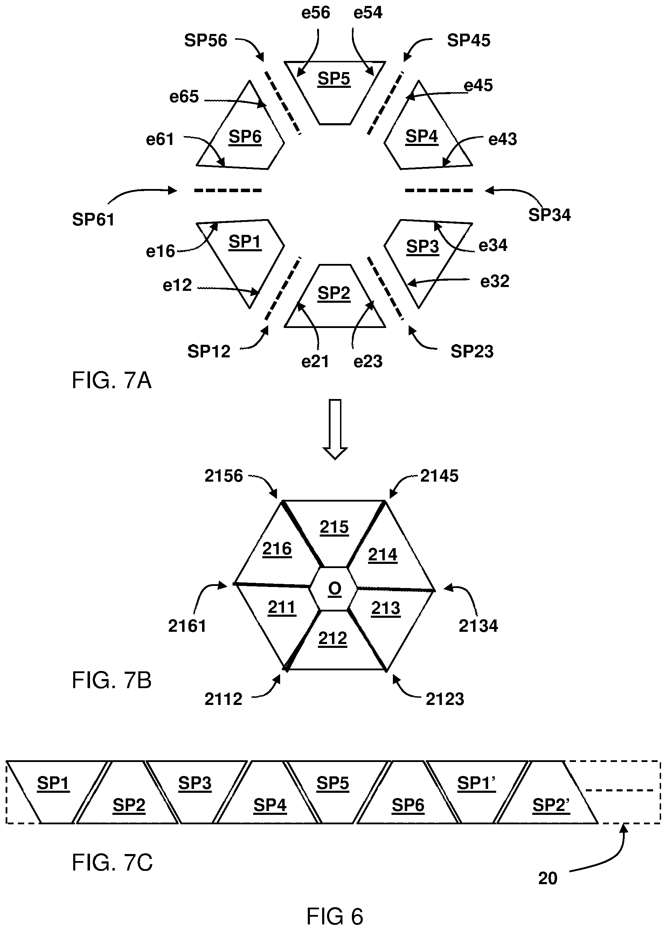

FIG. 6A-6D schematically show an aspect of a method of manufacturing a solar panel product. Therein FIG. 5A shows how preformed solar panels 1A, 1B, 1A', 1B' etc,... each having three, trapezoidal planar sections S1-S3, S4-S6, S1'-S3', S4'-S6' are manufactured as portions of a planar semi-finished product with a thermoplastically deformable back panel 20. These portions 1A, 1B, 1A', 1B' can be cut along lines C1, C2, C3 from the planar semi-finished product with very low material losses.

FIG. 6B shows how two preformed solar panels 1A, 1B are mutually positioned to be subsequently merged into a larger preformed solar panel 1AB, as shown in FIG. 6C. As shown in FIG. 5B, 5C, the two preformed solar panels 1A, 1B are merged by contacting the first intermediate edge portion e12 of portion 1A and the second intermediate edge portion e21 of portion 1B and heating these edge portions e12, e21 for a time and temperature suitable to fuse the first and the second preformed solar panel 1A, 1B to obtain the preformed solar panel 1AB of FIG. 6C with at least three planar sections. Optionally, contacting, may be achieved via a strip of a thermoplastically deformable material, in that case also that strip is to be heated, at least at the locations where it contacts the intermediary edge portions e12, e21, for a time and temperature suitable to fuse therewith.

In the final step, shown in FIG. 5C, 5D, in the same manner, the remaining edge portions e1, e2 of the preformed solar panel 1AB are connected to form the solar-panel pyramid 1.

The thermoplastically deformable back panel 20 of the semi-finished product used in this method may comprise photovoltaic layer sections that will form the photovoltaic layer 3 in the end product 1. Also a protective layer upon the photovoltaic layer sections may be provided as part of the semi-finished product. Alternatively the photovoltaic layer sections and or a protective layer may be provided after the pyramid 2 is constructed from the semi-finished product.

FIG. 7A, 7B show an alternative method. Therein the planar sections 211,...,216 of the pyramidal wall 21 to be formed are provided as respective planar solar panel elements SP1,...,SP6 comprising a thermoplastically deformable back panel. The planar solar panel elements SP1,...,SP6 have respective pairs of edge portions. E.g. planar solar panel element SP1 has edge portions e12, e21, element SP2 has edge portions; e23, e32 etc.

As shown in FIG. 7B, the planar solar panel elements SP1,...,SP6 that are to form the planar sections 211,...,216 of the pyramid are pairwise contacted at their edge portions. The contacted edge portions are heated for a time and temperature suitable to pairwise fuse the solar panel elements along a plastically deformed section. The plastically deformed sections 2112, ..., 2161 each comprise the contacted edge portions of the pair of solar panel elements fused therein. The plastically deformed sections 2112, ..., 2161 maintain the pairwise contacted planar solar panel elements, forming the planar sections 211,..., 216, relative to each other at an enclosed angle in a range between 30° and 170°. As shown in FIG. 7C, the planar solar panel elements, e.g. SP1,...,SP6 can be cut from a semi-finished product 20, according to an alternating pattern. I.e. the contour of a planar solar panel element to be separated from the semi-finished product is mirrored with respect to the preceding one. It is an advantage of this approach, that the planar solar panel elements, e.g. SP1,...,SP6 can be obtained from the semi-finished product 20 with a minimum of material losses.

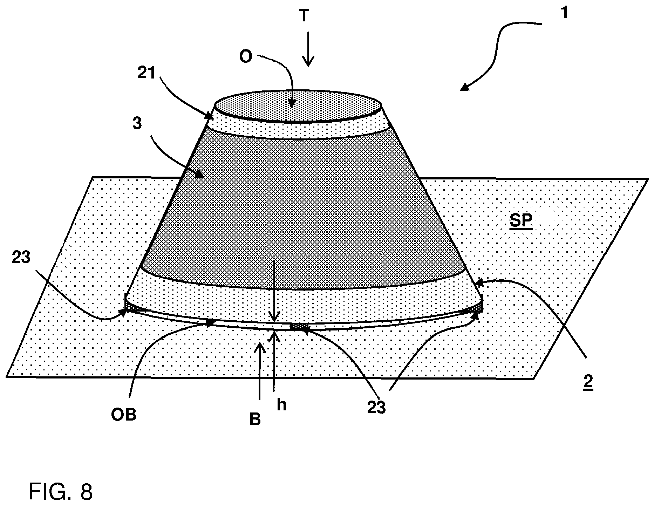

FIG. 8 shows a further embodiment, wherein the taper 2 of the solar panel product 1 is a cone with a plastically deformed taper wall 21. The taper is arranged on legs 23, so as to provide for an opening OB at the bottom that allows water to flow out of its interior. The surface area $A_{OB}$ of this opening is equal to the product of the circumference C of the taper at the base side times the height h with which it is arranged above the level of the support SP.

Accordingly $A_{OB} = 2\pi Rh$, wherein R is the radius of the cone 2 at its base side. The surface area AOB of the opening OB should be at most equal to the surface area $A_O$ of the topside opening O, which is equal to $\pi r^2$, wherein r is the radius of that opening O.

Alternatively, the cone 2 may be arranged with its base side against the supporting surface SP and one or more separate openings may be provided in the taper wall 21. In that case, a total surface area defined by these openings is at most equal to the surface area AO of the topside opening or to a total surface area of a plurality of openings at the top side if applicable. In other cases a pump mechanism may be provided to periodically remove water in the interior of the taper. Optionally leafs or other materials may be removed regularly as part of a maintenance scheme.

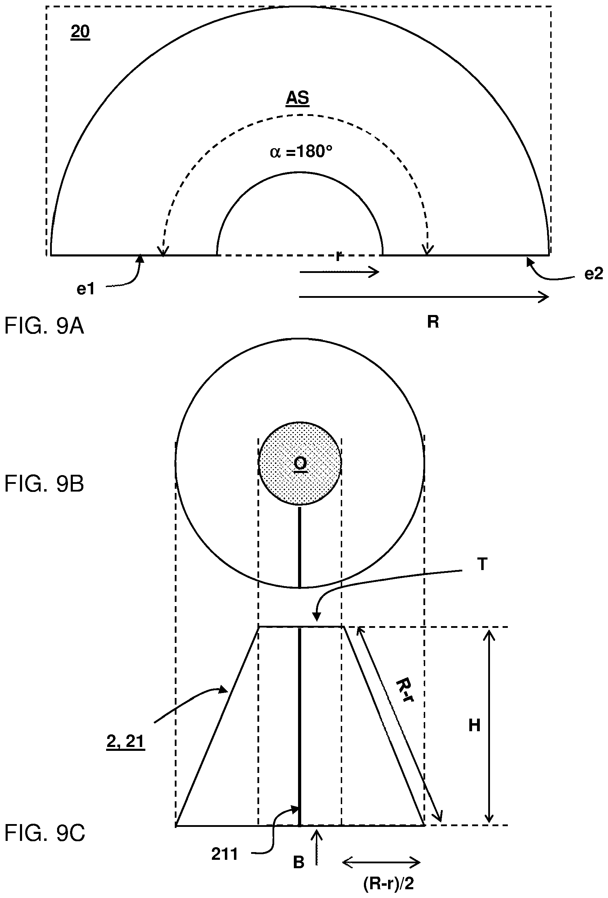

FIG. 9A-9C show a method of manufacturing a cone shaped solar panel product 1.

In a first step, as shown in FIG. 9A a thermoplastically deformable back panel 20 is provided.

As further shown in FIG 9A, an angular section AS of a ring is cut from the back panel 20. The angular section has an inner radius r and an outer radius R, and has a first and a second edge portion e1, e2.

As shown in FIG. 9B, 9C, the angular section AS is plastically deformed to assume the shape of a cone 2 having a wall 21, wherein the first and the second edge portion e1, e2 contact each other. Therein FIG. 9B shows a top view and FIG. 9C shows a side view.

The contacted edge portions e1, e2 are heated for a time and temperature suitable to fuse the angular section at its edge portions along a fused region 211 to form the taper wall 21. Subsequent to these steps a photovoltaic layer 3 may be applied on the taper wall 21, and also a protective layer (not shown) may be applied thereon. Alternatively embodiments may be contemplated wherein the thermoplastically deformable back panel 20 used in the method may already have a photovoltaic layer 3 and optionally a protective layer. Edge portions e1, e2 to be fused may be pairwise contacted via a strip of a thermoplastically deformable material and heated together with the edge portions to form the fused region 211. It is also possible to use elastically deformable materials instead of thermoplastic materials and to connect the edge portions otherwise, e.g. by mechanical means or by an adhesive.

In the embodiment shown, the angular section extends over an angle of 180 degrees. In that case the radius of the cone 2 at its base side and at its top side respectively are equal to half the outer radius R and the inner radius r of the angular section AS of the ring. Therewith it can be computed that the height H of the cone 2 is equal to:

$$H = (R\text{-}r)*\sqrt{(3/4)}$$

If general, an angular section with an angle α may be used. In the general case, the radius of the cone 2 at its base side and at its top side respectively are equal to α/360 the outer radius R and the inner radius r of the angular section AS of the ring. The height H in the general case is

$$H = (R - r) \sqrt{\frac{360^2 - \alpha^2}{360^2}}$$

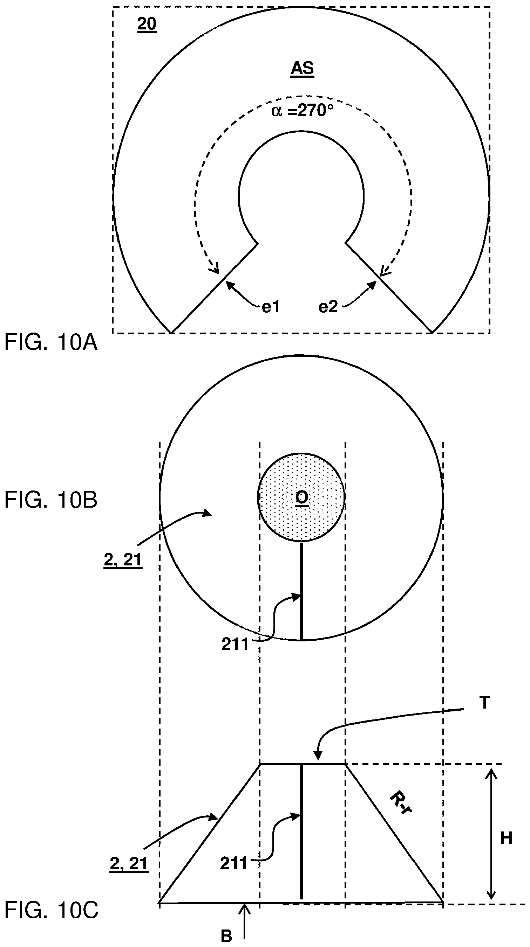

In the example of FIG. 10A, 10B, 10C, an angular section having an angle of 270 degrees is used, in which case the height of the cone 2 obtained is

$$H = (R-r)^* \sqrt{(7/16)}$$

A laminate to be used as a semi-finished product in methods as described herein may comprise a backsheet, a photo-active layer with conductive elements and a frontsheet for example of a polymer or a thin glass. Generally, it is desired to keep the laminate as thin as possible for more flexibility to facilitate the manufacturing and to minimize weight and material costs. Thin-film PV technologies are, for example, amorphous silicon, CIGS, OPV, Perovskites, etc. Layers of a photovoltaic stack may be applied with thin-film technology in vacuum or by means of printing / coating processes. If necessary one or more extra support layers may be provided.

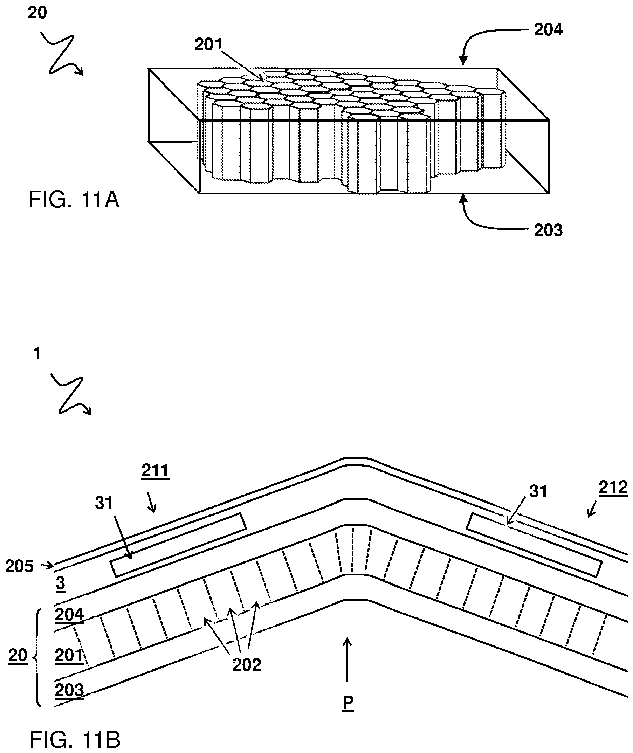

FIG. 11A, schematically shows an example of a back panel 20 that is particularly suitable for use in the methods as described herein for example with reference to FIG. 6A, 6B, 6C, 6D; FIG. 7A, 7B, 7C; FIG. 9A-9C; FIG. 10A-10C. The exemplary back panel 20 in FIG. 11A is a fiber reinforced panel. More in particular, the exemplary back-panel is a sandwich panel comprising a core layer 201 sandwiched between fiber reinforced front and back sheets 203, 204. Preferably, the core layer 201 is a porous spacer layer. Preferably, the core layer 201 is formed from a thermoplastic polymer. This thermoplastic polymer may be the same or a similar polymer or at least have a melting point close to that of the other thermoplastic polymers in the back panel. In some embodiments the porous layer may be a foam, a closed cell structure or an open cell structure. Advantageously a porous spacer layer 201 (core layer) may be compressed, e.g. molten, from an initial thickness to a reduced thickness. Advantageously, providing a porous spacer layer 201 maintains the advantage of providing a desired stiffness while improving, e.g. reducing, the weight (mass per unit area) needed to attain said stiffness. The core layer 201 may comprise biodegradable materials such as hemp fibers and paper (cardboard). In a preferred embodiment, the porous spacer layer 12 comprises laterally connected pores. Using a core with laterally connected pores allows evacuating air and humidity between layers in the stack, e.g. during manufacturing, e.g. lamination. Applying a vacuum between layers during lamination mitigates evaporation of residues, e.g. humidity (water) and/or solvent traces from the compounds forming the layers. This allows use of stable processing conditions, e.g. lamination conditions. Optionally the voids, e.g. pores may remain evacuated (under vacuum) in the laminated panel. Alternatively, filling with an inert gas, usage of evacuated pores may improve thermal insulation properties of the panel, e.g. during assembly on a building. In some preferred embodiments, e.g. as shown in FIG 11A, the core layer 201 is a honeycomb panel. Honeycomb panels combine light-weight properties with stable spacing functionality. Advantageously, sandwich panels comprising honeycomb panel 201 sandwiched between a fiber reinforced thermoplastic polymer top layer 204 and a fiber reinforced thermoplastic polymer bottom layer 203, may have a bending stiffness that is independent or nearly independent on bending direction, e.g. the same or nearly the same in a X and Y direction of the panel.

Preferably the core layer 201 is formed of a thermoplastic honeycomb panel, e.g. such as panels provided by Econcore® and described in a patent application with number WO2006053407. Such thermoplastic honeycomb panels may advantageously be produced from PP in a continuous process. In this process a heated sheet of thermoplastic polymer is molded into a honey-comb shape which gains stability upon cooling below a melting temperature of the sheet. By virtue of the manufacturing process such honeycomb panels 201 possess a closed cell structure with pores 202 (See FIG. 11B) in a direction along its manufacturing direction and an open or semi-open porous structure in a direction perpendicular to its manufacturing direction. Advantageously, such honeycomb panel may be formed entirely of thermoplastic polymers, e.g. PP, allowing efficient recycling of said panels, e.g. by melting and re-forming. Advantageously the thickness of the honeycomb panel may be controlled (e.g. set) by mere selection of a suitable mold.

FIG. 11B shows an exemplary application of the back panel 20 in sections 211, 212 of a wall 21 of the truncated pyramid shaped solar panel product 1 in FIG. 6D for example. Photovoltaic cells 31 of a photovoltaic layer 3 are protected by a protective layer 205. The photovoltaic layer 3 and the protective layer 205 may be deformed into the desired shape as part of the back panel 20 used in the manufacturing procedure. Alternatively, these layers may be provided at the end of the manufacturing procedure.

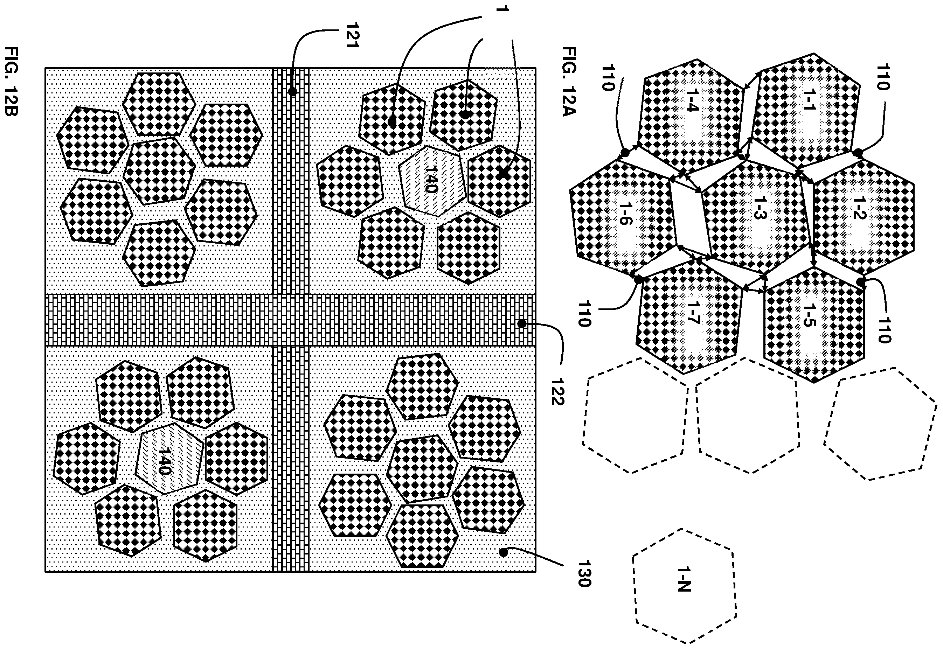

FIG. 12A, 12B, show examples of a solar panel pyramid arrangement that comprises a plurality of solar-panel pyramids 1-1, 1-2, ....,1-N. In the embodiment of FIG. 12A, mutually neighboring solar-panel pyramids are mechanically elastically coupled, here by flexible joints 110. Alternatively or additionally flexible joints 111may be provided at an other location, for example at each side at a central position of a respective neighboring side of neighboring pyramids.

Buffer elements (not shown) may be provided to avoid that neighboring solar-panel pyramids can directly touch each other. Alternatively, as shown in FIG. 12B, the solar-panel pyramids may be mounted to a web, which may be pretensioned. In the embodiment of FIG. 12B, also maintenance paths 121, 122 are provided that extend through the arrangement, to enable access of individual solar-panel pyramids. At some locations vacancies 140 are provide where the sea surface is exposed to allow sunlight to enter the water surface, and to provide for a contact with the atmosphere.

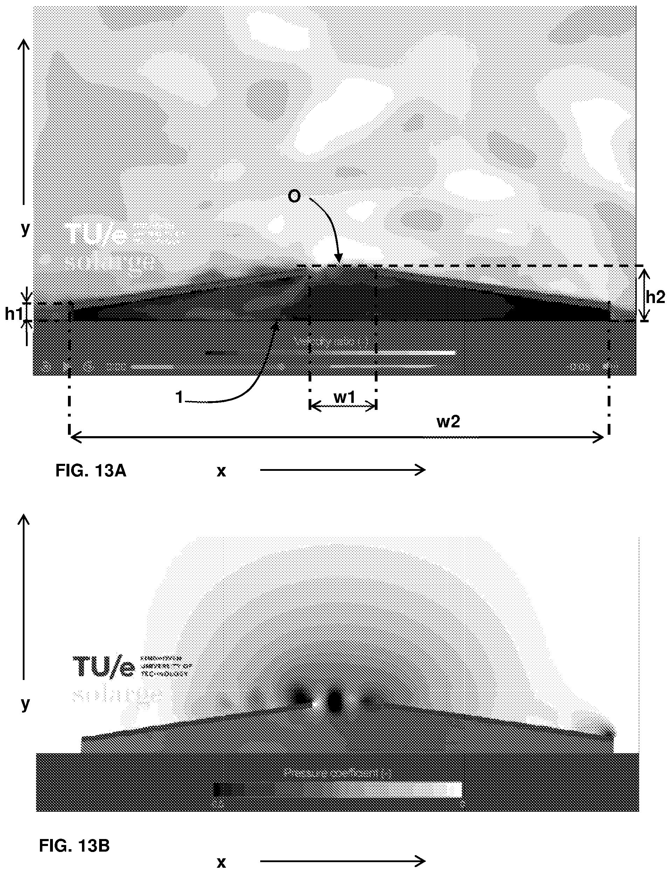

FIG. 13A and FIG. 13B show various simulation results obtained with a CFD (computational fluid dynamics) numerical simulation using ANSYS Fluent 16.1.

The solar panel product 1 is modeled therein as a truncated rectangular pyramid having sides w1 of 1.68 m and an opening of 0.32 x 0.32 m at the top. It is presumed that the truncated rectangular pyramid is arranged at a shield at a height h1 = 0.05 cm above the carrier surface. The shield fully encloses the lower side of the pyramid. It is further specified in the model that the height h2 of the pyramid at the level of the opening O is 0.18 m above the carrier surface..

FIG. 13A illustrates how the wind velocity as a function of the location relative to the tapering solar panel product 1. Therein the whitelevel is proportional to the local air velocity. As can be seen in FIG. 13A, the air velocity is relatively high near the top of the truncated tapering solar panel product.

The wind velocity is visually represented as a dimensionless parameter $U(x,y,z)/U0$, wherein the gray value varies linearly with this dimensionless parameter. Therein black represents the value 0 and white represents the value 1.

FIG. 13B visually represents a dimensionless pressure coefficient $C_p(x,y,z)$, which is defined as follows:

$$Cp = (P(x,y,z) - P_0)/(0.5 \times \rho \times U_0^2),$$

therein

$P(x,y,z)$: is the local pressure (in $N/m^2$)
$P_0$: is the reference pressure (in $N/m^2$)
$\rho$: is the density of the air (1.225 $kg/m^3$)
$U_0$: is the velocity of the air in the direction x (m/s) at a sufficient distance from the product.

In this visual representation the gray value is linearly related to the value of Cp, wherein black indicates a Cp value of -0.5 and white indicates a Cp value of 1.

As shown further in FIG. 13B, therewith the local air pressure is low as compared to the air pressure near the tapering solar panel product but below its top. As the tapering solar panel product has an opening O near the top, the pressure in the interior of the tapering solar panel product is also lower than the pressure that is exerted at the exterior on its wall. Therewith the tapering solar panel product is stabilized and therewith reducing or completely obviating the need for fixation elements.

Embodiments of the tapering solar panel product (T1, T2, T3, T4) as claimed herein were subjected to a wind tunnel test. Also, as a reference, non-claimed products (R1,R2) were subjected to this test.

In any of these cases the tapering solar panel product is provided as a 4-sided pyramid having a basis size w1 of 1.68 x 1.68 m and with side faces at an angle of 10 degrees with reference to a carrier plane.

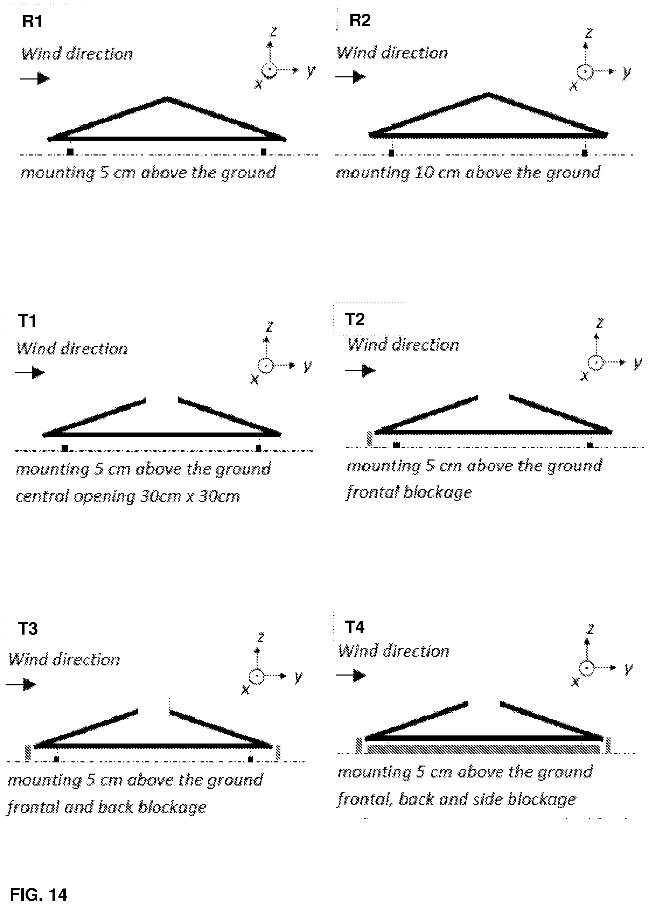

For all measurements, the tapering solar panel product was mounted on four 3D-force sensors, the axis orientation with respect to the wind direction is shown in FIG. 14. The sensors were aligned in such a way that side forces Fx acted in the direction of *x,* drag forces Fy acted in the direction of *y* and lift forces Fz acted in the direction of *z.* Measurements were performed for different configurations and approach flow angles, details of which are given in Table 1 and illustrated in FIG. 14. All measurements were conducted at 25 m/s for 30 seconds. All results were corrected for differences in temperature, atmospheric pressure and relative humidity during the measurements. Corresponding forces, shown in Table 2, were calculated for an assumed wind speed of 24.5 m/s and standard atmospheric conditions (15°C at 0 m (sea level) and standard atmospheric pressure 101325 Pa), resulting in a density of air of 1.225 kg/m3.

Table 1: properties of the tested products. Products T3-T6 were provided with a square opening of 32 x 32 cm obtained by truncating the four-sided pyramid at its top. The value h1 indicates the height with which the product is positioned above the carrier plane. It is further denoted whether (F,B,S) or not (None) shields are provided between the carrier plane and the lower edge of the product. Therein the capitals F,B,S respectively denote front, back and side shield. The products R1, R2 have a height of 16 cm. The products T1-T4, which are truncated have a height of 13 cm. The total height h2 above the carrier plane is indicated in the table.

| Product | Opening(cm$^2$) | h1 (cm) | h2 (cm) | Shield |
|---|---|---|---|---|
| R1 | None | 5 | 21 | None |
| R2 | None | 10 | 26 | None |
| T1 | 32x32 | 5 | 18 | None |
| T2 | 32x32 | 5 | 18 | F |
| T3 | 32x32 | 5 | 18 | F+B |
| T4 | 32x32 | 5 | 18 | F+B+S |

The measurement results are presented in Table 2. Therein:
The first column indicates the product PD subjected to the test, the second to the fourth column indicate the corresponding area force coefficients and the fifth to the sixth column indicate the corresponding forces for conditions mentioned above.

| PD | $ACx$ [m2] | $ACy$ [m2] | $ACz$ [m2] | $Fx$ [N] | $Fy$ [N] | Fz[N] |
|---|---|---|---|---|---|---|
| R1. | 0.000 | 0.104 | 0.522 | -0.1 | 38.1 | 191.7 |
| R2. | -0.001 | 0.138 | 0.656 | -0.2 | 50.9 | 241.4 |
| T1. | 0.002 | 0.121 | 0.235 | 0.7 | 44.5 | 86.6 |
| T2. | -0.001 | 0.000 | -0.130 | -0.5 | -0.2 | -47.9 |
| T3. | -0.006 | -0.001 | -0.086 | -2.3 | -0.2 | -31.7 |
| T4. | -0.002 | -0.001 | -0.089 | -0.8 | -0.2 | -32.7 |

As becomes apparent from the above, the geometry of the claimed tapering solar panel product mitigates lift forces thereon. From a comparison of the results for T1 and R1 it becomes apparent that the lift force Fz is reduced with more than a factor 2. In case that a flow of wind below the product is mitigated or completely avoided (as for T2, T3, T4), it is even the case that the resultant force Fz in the z-direction becomes negative. In other words, the product is pressed against the supporting surface. Also, in that case, the net force Fy exerted by the wind on the product is reduced to virtually 0. In any case the force Fx exerted in the direction transverse to the wind is negligible. Hence in case that a flow of wind below the product is mitigated or completely avoided, the downward directed force Fz and the resulting friction of the product with the supporting surface will be sufficient to maintain the product at its place without requiring the product to be fixed. To take into account any wind direction it may be recommended to provide the product with a front, back and side shield. Alternatively, the product may be positioned directly on the supporting surface, leaving no space below. When the product is arranged above the supporting surface, a single shield may be sufficient if that shield faces the direction from which the wind originates, and as long as that direction does not change. Should this be the case, it can be repositioned.

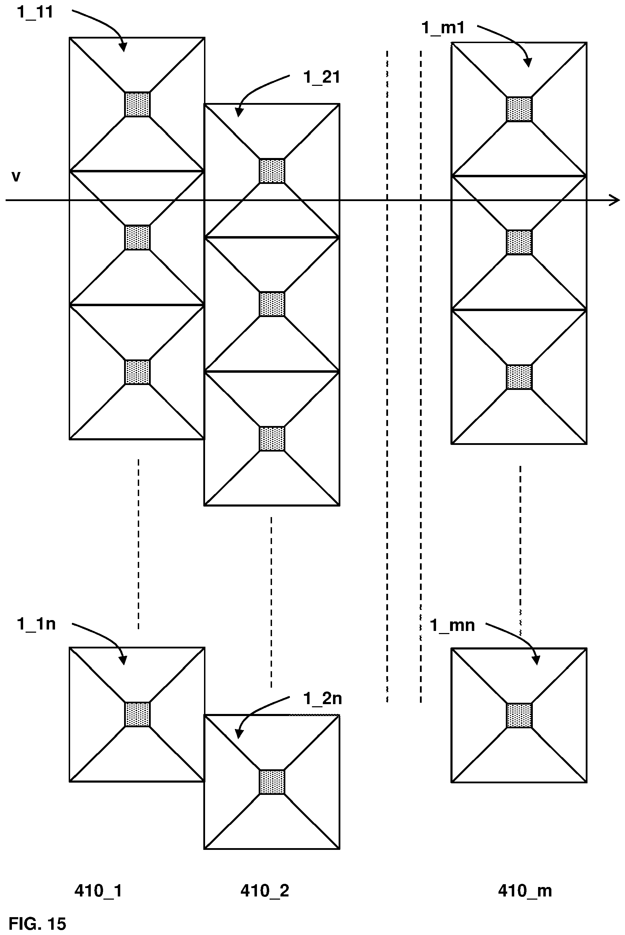

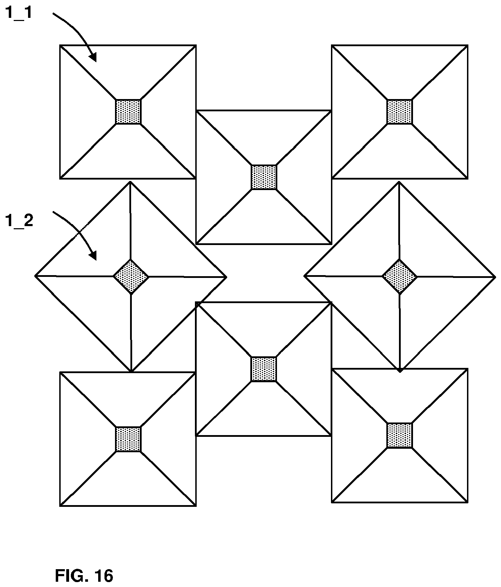

An even further improvement is achieved with a solar panel arrangement as shown in FIG. 15. In this embodiment the solar panel products are arranged in rows 410_1, 410_2,...,410_n, wherein each next row is shifted in the length direction of the row with respect to its predecessor. The rows 410_j comprises solar panel products 1_j1, ..., 1_jn. . For example row 410_1 comprises solar panel products 1_11, ..., 1_1n. Due to the fact that in this embodiment the solar panel products are not aligned in the direction v, the wind having that direction will be dispersed when traversing the arrangement and become turbulent so that sub atmospheric conditions at one side of the individual solar panel pyramid are avoided. Therewith dragging forces are further reduced. In circumstances where the wind has a more inpredictable direction, the solar panel products can be arranged in a more random manner, as shown for example in FIG. 16, wherein some solar panel products, e.g. 1_2, are rotated with respect to other ones, e.g. 1_1.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

**Claims**

1. A solar panel product (1), comprising a taper (2) with a top side (T) and opposite thereto a base side (B), where the taper is to be carried by a supporting surface (SP), the taper having a taper wall (21) that extends around an axis (AX) from the base side to the top side, the taper wall tapering inwards in the direction from the base side (B) to the top side (T), wherein at least a part of an outer area of the taper wall (21) is provided with a photovoltaic layer (3), **characterized in that** the taper has one or more openings (O) at its top side.

2. The solar panel product (1) according to claim 1, wherein the taper (2) is truncated at its top side (T) therewith defining an opening (O) that is one of said one or more openings.

3. The solar panel product (1) according to claim 2, having one or more extension parts (22) extending from the top side of the taper wall (21) in a direction away from the base side (B).

4. The solar panel product (1) according to claim 1 or 2, wherein at least one opening of the one or more openings (O1,...,O6) is provided in the taper wall (21).

5. The solar panel product according to one of the previous claims, wherein the taper wall (21) has one or more further openings (OB) at its base side (B), and wherein a total surface area defined by said one or more further openings (OB) is at most equal to a total surface area of said one or more openings (O) at its top side.

6. The solar panel product according to one of the claims 1-4, wherein the taper wall (21) is closed at its base side (B), and wherein a total surface area of said one or more openings (O) at its top side is at least 5% of a surface area enclosed by the circumference of the taper wall (21) at its base side.

7. The solar panel product (1) according to one of the claims 1-6, wherein the taper (2) is a pyramid with a taper wall (21) formed by at least three planar sections with a triangular or trapezoidal shape, wherein at least one of said at least three planar sections is provided with a photovoltaic layer (3), wherein optionally a respective plastically deformed section is present between each pair of mutually adjacent planar sections to maintain said mutually adjacent planar sections relative to each other at an enclosed angle (A1) in a range between 30° and 170°, wherein optionally the respective plastically deformed section is formed of a weld connecting adjacent planar sections.

8. The solar panel product (1) according to one of the claims 1-6, wherein the taper is a cone having a plastically or elastically deformed taper wall (21).

9. The solar panel product (1) according to one of the preceding claims, wherein the taper wall or a section thereof is formed of a stack comprising the photovoltaic layer (3) sandwiched between a back panel (20) and a protective front layer (205), wherein optionally the back panel (20) is a fiber reinforced panel, and/or wherein optionally the back panel (20) is a sandwich panel comprising a core layer (201) sandwiched between fiber reinforced front and back sheets (203, 204) the core layer (201) optionally being a porous layer, for example a honeycomb layer.

10. The solar panel product according to claim 7, wherein the at least three planar sections comprise a glass substrate, the at least three planar sections being mutually connected by an adhesive or by a mechanical construction.

11. The solar panel product according to one of the preceding claims, wherein an inclination of the taper wall (21) with respect to the supporting surface (SP) is at most 25°.

12. A method for manufacturing a solar panel product (1) according to claim 7, the method comprising:

- providing a semi-finished product comprising a thermoplastically deformable back panel (20) having a surface area comprising for each of said at least three planar sections (211, 212, 213) of said taper wall (21) a respective first surface area section (S1, S2, S3), wherein a first edge portion (e1) of a first one (S1) of said planar sections defines a first end (E1) and a second edge portion (e2) of a last one (S6) of said planar sections defines a second opposing end (E2), the surface area of the thermoplastically deformable back panel (20) further comprising a respective second surface area section (P12; P23) between each pair of adjacent first surface area sections (S1, S2; S2, S3);

- plastically deforming said second surface area sections (P12; P13) of the back panel (20),

- contacting and heating the first and the second edge portion (e1, e2), for a time and temperature suitable to fuse the first one (S1) and the last one (S6) of said substantially triangular planar sections along a plastically deformed section (P) to form a solar panel pyramid (100), wherein each of the deformed second surface area sections (2121; 2123) resulting from said deformation maintains the corresponding pair of adjacent planar sections relative to each other at an enclosed angle in a range between 30° and 170°, wherein optionally the semi-finished product is provided from a first precursor semi-finished product (1A) and a second precursor semi-finished product (1B), which each have a thermoplastically deformable back panel (20) and have a surface area with one or more of said first surface area sections, the total number of said first surface area sections, being equal to the number of said at least three planar sections, the first precursor semi-finished product (1A having said first edge portion (e1) as well as a first intermediate edge portion (e12), the second precursor semi-finished product (1B) having said second edge portion (e2), and further having a second intermediate edge-portion (e21),

- contacting and heating the first and the second intermediate edge portion (e12, e21), for a time and temperature suitable to fuse the first and the second precursor semi-finished product (1A,1B) to obtain the semi-finished product (1AB) with at least three planar sections.

13. The method according to claim 12, further comprising positioning at least one extension part (22) at a top side of the taper (2) formed in the previous steps, wherein an edge portion of said at least one extension part contacts a top side edge portion of said taper, and heating the contacted edge portions for a time and temperature suitable to fuse the extension part with the taper wall (21) at their contacting edge portions.

14. The method according to claim 12 or 13, wherein edge portions are pairwise contacted via a strip (SP12, SP23,...,SP61) of a thermoplastically deformable material, and wherein said heating includes heating the strip of a thermoplastically deformable material, the resulting plastically deformed sections (2112,...,2161) including said strip.

15. A solar panel product arrangement, comprising a plurality of species (1_11,...,1_1n, 1_21,...,1_2n, 1_m1,...,1_mn) of the solar panel product of either of claim 1-11, wherein the species are arranged in mutually shifted rows (410_1, 410_2,...,410_m) or wherein some species (e.g. 1_2) are oriented different from others (e.g. 1_1).

## Patentansprüche

1. Solarmodulprodukt (1), das eine Verjüngung (2) mit einer Oberseite (T) und einer dieser gegenüberliegenden Basisseite (B) umfasst, wobei die Verjüngung von einer Stützfläche (SP) zu tragen ist und eine konische Wand (21) aufweist, die sich um eine Achse (AX) von der Basisseite zur Oberseite erstreckt, wobei sich die konische Wand in der Richtung von der Basisseite (B) zur Oberseite (T) nach innen verjüngt, wobei zumindest ein Teil eines Außenbereichs der konischen Wand (21) mit einer photovoltaischen Schicht (3) versehen ist, **dadurch gekennzeichnet, dass** die Verjüngung eine oder mehrere Öffnungen (O) an ihrer Oberseite aufweist.

2. Solarmodulprodukt (1) nach Anspruch 1, wobei die Verjüngung (2) an ihrer Oberseite (T) abgeschnitten ist, wodurch eine Öffnung (O) definiert wird, die eine der genannten einen oder mehreren Öffnungen ist.

3. Solarmodulprodukt (1) nach Anspruch 2, mit einem oder mehreren Verlängerungsteilen (22), die sich von der Oberseite der konischen Wand (21) in eine Richtung weg von der Basisseite (B) erstrecken.

4. Solarmodulprodukt (1) nach Anspruch 1 oder 2, wobei mindestens eine Öffnung der einen oder mehreren Öffnungen (O1, ..., O6) in der konischen Wand (21) vorgesehen ist.

5. Solarmodulprodukt nach einem der vorhergehenden Ansprüche, wobei die konische Wand (21) eine oder mehrere weitere Öffnungen (OB) an ihrer Basisseite (B) aufweist, und wobei eine durch die eine oder mehreren weiteren Öffnungen (OB) definierte Gesamtoberfläche höchstens gleich einer Gesamtoberfläche der einen oder mehreren Öffnungen (O) an ihrer Oberseite ist.

6. Solarmodulprodukt nach einem der Ansprüche 1 bis 4, wobei die konische Wand (21) an ihrer Basisseite (B) geschlossen ist und wobei die Gesamtoberfläche der einen oder mehreren Öffnungen (O) an ihrer Oberseite mindestens 5 % der vom Umfang der konischen Wand (21) an ihrer Basisseite umschlossenen Oberfläche beträgt.

7. Solarmodulprodukt (1) nach einem der Ansprüche 1 bis 6, wobei die Verjüngung (2) eine Pyramide mit einer konischen Wand (21) ist, die durch mindestens drei ebene Abschnitte mit einer dreieckigen oder trapezförmigen Form gebildet wird, wobei mindestens einer der mindestens drei ebenen Abschnitte mit einer photovoltaischen Schicht (3) versehen ist, wobei optional ein jeweiliger plastisch verformter Abschnitt zwischen jedem Paar von gegenseitig benachbarten ebenen Abschnitten vorhanden ist, um die gegenseitig benachbarten ebenen Abschnitte relativ zueinander in einem eingeschlossenen Winkel (A1) in einem Bereich zwischen 30° und 170° zu halten, wobei optional der jeweilige plastisch verformte Abschnitt aus einer Schweißung gebildet ist, die benachbarte ebene Abschnitte verbindet.

8. Solarmodulprodukt (1) nach einem der Ansprüche 1 bis 6, wobei die Verjüngung ein Kegel mit einer plastisch oder elastisch verformten konischen Wand (21) ist.

9. Solarmodulprodukt (1) nach einem der vorhergehenden Ansprüche, wobei die konische Wand oder ein Abschnitt davon aus einem Stapel gebildet ist, der die photovoltaische Schicht (3) umfasst, die zwischen einer Rückwand (20) und einer schützenden Frontschicht (205) angeordnet ist, wobei optional die Rückwand (20) eine faserverstärkte Platte ist, und/oder wobei optional die Rückwand (20) eine Sandwichplatte ist, die eine Kernschicht (201) umfasst, welche zwischen faserverstärkten Vorder- und Rückseitenplatten (203, 204) angeordnet ist, wobei die Kernschicht (201) optional eine poröse Schicht, beispielsweise eine Wabenschicht, ist.

10. Solarmodulprodukt nach Anspruch 7, wobei die mindestens drei ebenen Abschnitte aus einem Glassubstrat bestehen und die mindestens drei ebenen Abschnitte durch einen Klebstoff oder eine mechanische Konstruktion miteinander verbunden sind.

11. Solarmodulprodukt nach einem der vorhergehenden Ansprüche, wobei eine Neigung der konischen Wand (21) in Bezug auf die Stützfläche (SP) maximal 25° beträgt.

12. Verfahren zur Herstellung eines Solarmodulprodukts (1) nach Anspruch 7, das Verfahren umfassend:

    - Bereitstellen eines Halbfertigprodukts, das eine thermoplastisch verformbare Rückwand (20) mit einem Oberflächenbereich umfasst, der für jeden der mindestens drei ebenen Abschnitte (211, 212, 213) der besagten konischen Wand (21) einen jeweiligen ersten Oberflächenabschnitt (S1, S2, S3) umfasst, wobei ein erster Kantenabschnitt (e1) eines ersten (S1) der ebenen Abschnitte ein erstes Ende (E1) definiert, und ein zweiter Kantenabschnitt (e2) eines letzten (S6) der ebenen Abschnitte ein zweites gegenüberliegendes Ende (E2) definiert, und der Oberflächenabschnitt der thermoplastisch verformbaren Rückwand (20) ferner einen jeweiligen zweiten Oberflächenabschnitt (P12; P23) zwischen jedem Paar von benachbarten ersten Oberflächenabschnitten umfasst (S1, S2; S2, S3);
    - plastisches Verformen der besagten zweiten Oberflächenabschnitte (P12; P13) der Rückwand (20),
    - Kontaktieren und Erwärmen des ersten und des zweiten Kantenabschnitts (e1, e2) für eine Zeit und eine Temperatur, die geeignet sind, den ersten (S1) und den letzten (S6) der im Wesentlichen dreieckigen ebenen Abschnitte entlang eines plastisch verformten Abschnitts (P) zu verschmelzen, um eine Solarmodul-Pyramide (100) zu bilden, wobei jeder der verformten zweiten Oberflächenabschnitte (2121; 2123), die aus der besagten Verformung resultieren, das entsprechende Paar benachbarter ebener Abschnitte relativ zueinander in einem eingeschlossenen Winkel in einem Bereich zwischen 30° und 170° hält, wobei optional das Halbfertigprodukt aus einem ersten Vorläufer-Halbfertigprodukt (1A) und einem zweiten Vorläufer-Halbfertigprodukt (1B) bereitgestellt wird, die jeweils eine thermoplastisch verformbare Rückwand (20) und eine Oberfläche mit einem oder mehreren der ersten Oberflächenabschnitte aufweisen, wobei die Gesamtzahl der besagten ersten Oberflächenabschnitte gleich der Anzahl der mindestens drei ebenen Abschnitte ist, wobei das erste Vorläufer-Halbfertigprodukt (1A) den ersten Kantenabschnitt (e1) sowie einen ersten Zwischenkantenabschnitt (e12) aufweist, und das zweite Vorläufer-Halbfertigprodukt (1B) den zweiten Kantenabschnitt (e2) und ferner einen zweiten Zwischenkantenabschnitt (e21) aufweist.
    - Kontaktieren und Erwärmen des ersten und des zweiten Zwischenkantenabschnitts (e12, e21) für eine Zeit und eine Temperatur, die geeignet sind, das erste und das zweite Vorläufer-Halbfertigprodukt (1A, 1B) zu verschmelzen, um das Halbfertigprodukt (1AB) mit mindestens drei ebenen Abschnitten zu erhalten.

13. Verfahren nach Anspruch 12; es umfasst ferner das Positionieren mindestens eines Verlängerungsteils (22) an einer Oberseite der in den vorhergehenden Schritten gebildeten Verjüngung (2), wobei ein Kantenabschnitt mindestens eines Verlängerungsteils einen oberen Kantenabschnitt der Verjüngung berührt, sowie das Erhitzen der berührten Kantenabschnitte für eine Zeit und Temperatur, die geeignet sind, das Verlängerungsteil mit der konischen Wand (21) an ihren berührenden Kantenabschnitten zu verschmelzen.

14. Verfahren nach Anspruch 12 oder 13, wobei die Kantenabschnitte paarweise über einen Streifen (SP12, SP23, ..., SP61) aus einem thermoplastisch verformbaren Material berührt werden, und wobei das besagte Erwärmen das Erhitzen des Streifens aus einem thermoplastisch verformbaren Material beinhaltet, und die resultierenden plastisch verformten Abschnitte (2112, ..., 2161) den Streifen beinhalten.

15. Solarmodul-Produktanordnung, die eine Vielzahl von Arten (1_11,...,1_1n, 1_21,...,1_2n, 1_m1,...,1_mn) des Solarmodulprodukts nach einem der Ansprüche 1-11 umfasst, wobei die Arten in zueinander versetzten Reihen (410_1, 410_2,...,410_m) angeordnet sind oder wobei einige Arten (z.B. 1_2) anders als andere (z.B. 1_1) ausgerichtet sind.

## Revendications

1. Produit formant panneau solaire (1), comprenant une conicité (2) avec un côté supérieur (T) et à l'opposé de celui-ci un côté de base (B), où la conicité doit être porté par une surface de support (SP), la conicité ayant une paroi de la conicité (21) qui s'étend autour d'un axe (AX) depuis le côté de base vers le côté supérieur, la paroi de la conicité se rétrécissant vers l'intérieur dans la direction allant du côté de base (B) vers le côté supérieur (T), dans lequel au moins une partie d'une zone externe de la paroi de la conicité (21) est dotée d'une couche photovoltaïque (3), **caractérisé en ce que** la conicité présente une ou plusieurs ouvertures (O) au niveau de son côté supérieur.

2. Produit formant panneau solaire (1) selon la revendication 1, dans lequel la conicité (2) est tronquée au niveau de son côté supérieur (T), définissant ainsi une ouverture (O) qui est l'une desdites une ou plusieurs ouvertures.

3. Produit formant panneau solaire (1) selon la revendication 2, ayant une ou plusieurs parties d'extension (22) s'étendant depuis le côté supérieur de la paroi de la conicité (21) dans une direction opposée au côté de base (B).

4. Produit formant panneau solaire (1) selon la revendication 1 ou 2, dans lequel au moins une ouverture de la ou des ouvertures (01, O6) est prévue dans la paroi de la conicité (21).

5. Produit formant panneau solaire selon l'une des revendications précédentes, dans lequel la paroi de la conicité (21) présente une ou plusieurs autres ouvertures (OB) au niveau de son côté de base (B), et dans lequel une surface totale définie par ladite ou lesdites autres ouvertures (OB) est au plus égale à la surface totale desdites une ou plusieurs ouvertures (O) au niveau de son côté supérieur.

6. Produit formant panneau solaire selon l'une des revendications 1 à 4, dans lequel la paroi de la conicité (21) est fermée au niveau de son côté de base (B), et dans lequel une surface totale de ladite ou desdites ouvertures (O) au niveau de son côté supérieur représente au moins 5 % d'une surface délimitée par la circonférence de la paroi de la conicité (21) au niveau de son côté de base.

7. Produit formant panneau solaire (1) selon l'une des revendications 1 à 6, dans lequel la conicité (2) est une pyramide avec une paroi de la conicité (21) formée par au moins trois sections planes de forme triangulaire ou trapézoïdale, dans lequel au moins l'une desdites au moins trois sections planes est dotée d'une couche photovoltaïque (3), dans lequel facultativement, une section respective déformée plastiquement est présente entre chaque paire de sections planes mutuellement adjacentes pour maintenir lesdites sections planes mutuellement adjacentes les unes par rapport aux autres à un angle inclus (AI) dans une plage comprise entre 30° et 170°, dans lequel facultativement la section plane déformée plastiquement respective est formée d'une soudure reliant les sections planes adjacentes.

8. Produit formant panneau solaire (1) selon l'une des revendications 1 à 6, dans lequel la conicité est un cône ayant une paroi de la conicité (21) déformée plastiquement ou élastiquement.

9. Produit formant panneau solaire (1) selon l'une des revendications précédentes,

dans lequel la paroi de la conicité ou une section de celle-ci est formée d'un empilement comprenant la couche photovoltaïque (3) prise en sandwich entre un panneau arrière (20) et une couche avant de protection (205), dans lequel le panneau arrière (20) est facultativement un panneau renforcé de fibres, et/ou dans lequel éventuellement le panneau arrière (20) est un panneau sandwich comprenant une couche centrale (201) prise en sandwich entre des feuilles avant et arrière renforcées par des fibres (203, 204), la couche centrale (201) étant éventuellement une couche poreuse, par exemple une couche en nid d'abeille.

10. Produit formant panneau solaire selon la revendication 7, dans lequel les au moins trois sections planes comprennent un substrat de verre, les au moins trois sections planes étant reliées mutuellement par un adhésif ou par une construction mécanique.

11. Produit formant panneau solaire selon l'une des revendications précédentes, dans lequel une inclinaison de la paroi de la conicité (21) par rapport à la surface de support (SP) est d'au plus 25°.

12. Procédé de fabrication d'un produit formant panneau solaire (1) selon la revendication 7, le procédé comprenant les étapes consistant à :

fournir un produit semi-fini comprenant un panneau arrière thermoplastiquement déformable (20) ayant une surface comprenant pour chacune desdites au moins trois sections planes (211, 212, 213) de ladite paroi de la conicité (21) une première section de surface respective (S1, S2, S3), dans lequel une première partie de bord (el) d'une première (S1) desdites sections planes définit une première extrémité (E1) et une deuxième partie de bord (e2) d'une dernière (S6) desdites sections planes définit une deuxième extrémité opposée (E2), la surface du panneau arrière thermoplastiquement déformable (20) comprenant en outre une deuxième section de surface respective (P12 ; P23) entre chaque paire de premières sections de surface adjacentes (S1, S2 ; S2, S3) ;
déformer plastiquement lesdites deuxièmes sections de surface (P12 ; P13) du panneau arrière (20),
mettre en contact et chauffer la première et la deuxième partie de bord (el, e2), pendant une durée et une température appropriées pour fusionner la première (S1) et la dernière (S6) desdites sections planes sensiblement triangulaires le long d'une section déformée plastiquement (P) pour former une pyramide de panneau solaire (100), dans lequel chacune des deuxièmes sections de surface déformées (2121 ; 2123) résultant de ladite déformation maintient la paire correspondante de sections planes adjacentes l'une par rapport à l'autre à un angle inclus dans une plage entre 30° et 170° , où facultativement le produit semi-fini est fourni à partir d'un premier produit semi-fini précurseur (IA) et un deuxième produit semi-fini précurseur (1B), qui ont chacun un panneau arrière thermoplastiquement déformable (20) et ont une surface avec une ou plusieurs desdites premières sections de surface, le nombre total desdites premières sections de surface étant égal au nombre desdites au moins trois sections planes, le premier produit semi-fini précurseur (IA) comportant ladite première partie de bord (el) ainsi que une première partie de bord intermédiaire (e12), le deuxième produit semi-fini précurseur (1B) ayant ladite deuxième partie de bord (e2), et ayant en outre une deuxième partie de bord intermédiaire (e21),
mettre en contact et chauffer la première et la deuxième partie de bord intermédiaire (e12, e21), pendant une durée et une température appropriées pour fusionner le premier et le deuxième produit semi-fini précurseur (IA, 1B) pour obtenir le produit semi-fini (1AB) comportant au moins trois sections planes.

13. Procédé selon la revendication 12, comprenant en outre le positionnement d'au moins une partie d'extension (22) au niveau d'un côté supérieur de la conicité (2) formée dans les étapes précédentes, dans lequel une partie de bord de ladite au moins une partie d'extension entre en contact avec une partie de bord du côté supérieur.de ladite conicité, et chauffer les parties de bord en contact pendant une durée et une température appropriées pour fusionner la partie d'extension avec la paroi de la conicité (21) au niveau de leurs parties de bord en contact.

14. Procédé selon la revendication 12 ou 13, dans lequel les parties de bord sont mises en contact par paires via une bande (SP12, SP23 ....,, SP61) d'un matériau déformable thermoplastiquement, et dans lequel ledit chauffage comprend le chauffage de la bande d'un matériau thermoplastiquement déformable, les sections déformées plastiquement résultantes (2112, ..., 2161) incluant ladite bande.

15. Agencement d'un produit formant panneau solaire, comprenant une pluralité d'espèces (1_11,...,1_ln, 1_21, ... 1 2n, l_ml, ...,l_mn) du produit formant panneau solaire selon l'une des revendications 1 à 11, dans lequel les espèces sont disposées en rangées mutuellement décalées ( 410-1, 410_2,...,410_m) ou dans lequel certaines espèces (par exemple 1_2) sont orientées différemment des autres (par exemple 1_1).

FIG. 1

FIG. 2A

FIG 2A

FIG. 2B

FIG 2B

FIG. 3A

FIG. 3B

FIG. 4

FIG. 5

FIG. 6A

FIG. 6B

FIG. 6C

FIG. 6D

e56    e54

SP56                    SP45

e65                        e45

SP6      SP5      SP4      e43

e61

SP61                    SP34

e16    SP1      SP3      e34

e12                        e32

SP2

SP12            SP23

e21    e23

FIG. 7A

2156              2145

216    215    214

2161                    2134

211    O    213

212

2112              2123

FIG. 7B

SP1    SP3    SP5    SP1'

SP2    SP4    SP6    SP2'

FIG. 7C                                        20

FIG 6

FIG. 8

**FIG. 9A**

**FIG. 9B**

**FIG. 9C**

**20**

**AS**

α =270°

e1   e2

FIG. 10A

FIG. 10B

**O**

2, 21

211

FIG. 10C

2, 21

211

T

R-r

H

B

20

201 204

FIG. 11A

203

1

211

31 31 212

205

3

204

20 { 201 202

203

P

FIG. 11B

FIG. 12A

FIG. 12B

FIG. 13A

FIG. 13B

**FIG. 14**

1_11

1_21

1_m1

v

1_1n

1_2n

1_mn

410_1

410_2

410_m

FIG. 15

**FIG. 16**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20190024303
- US 2019183215 A
- US 2017278985 A
- WO 2014056176 A
- WO 2017081538 A2
- WO 2006053407 A